Europäisches Patentamt

European Patent Office

Office européen des brevets

(11) Veröffentlichungsnummer: **0 176 069**
**A1**

## (12) EUROPÄISCHE PATENTANMELDUNG

(21) Anmeldenummer: 85112022.0

(22) Anmeldetag: 23.09.85

(51) Int. Cl.⁴: **H 03 H 11/12**
H 03 H 11/34, H 03 F 3/45

(30) Priorität: 24.09.84 DE 3435016

(43) Veröffentlichungstag der Anmeldung:
02.04.86 Patentblatt 86/14

(84) Benannte Vertragsstaaten:
AT DE FR GB IT NL

(71) Anmelder: Siemens Aktiengesellschaft
Berlin und München Wittelsbacherplatz 2
D-8000 München 2(DE)

(72) Erfinder: Wilhelm, Wilhelm, Dr.
Geigenbergerstrasse 23
D-8000 München 71(DE)

(54) Hochpassschaltung mit Verstärker.

(57) Eine zwischen die Emitter einer Differenzverstärkerstufe geschaltete Kapazität (c) entkoppelt die beiden Transistoren (T1, T2) des Differenzverstärkers bis zu einer Grenzfrequenz. An den Anschlüssen der Kapazität (C) lassen sich Änderungen des Gleichtaktsignals und an den Lastwiderständen (R1, R2) der Hochpaßschaltung die verstärkten hochfrequenten Differenzsignale abgreifen und weiterverarbeiten. Verglichen mit herkömmlichen Schaltungen gleicher Funktion ist nur noch eine frequenzbestimmende kapazität (C) erforderlich, die zudem weniger belastet wird.

FIG 1

EP 0 176 069 A1

Siemens Aktiengesellschaft   Unser Zeichen 76069
Berlin und München          VPA   84 P 1750 E

## Hochpaßschaltung mit Verstärker

Die Erfindung betrifft eine Hochpaßschaltung mit Verstärker nach dem Oberbegriff des Patentanspruches 1.

Ein passiver Hochpaß erster Ordnung enthält eine im Signalweg zwischen der Ein - und Ausgangsklemme liegende Kapazität und einen von der Ausgangsklemme gegen das Bezugspotential geschalteten Widerstand. Die Ansteuerung eines derartigen Hochpasses geschieht niederohmig, z.B. über einen Emitterfolger. Da sich die Filtereigenschaften bei Belastung ändern, schaltet man dem Hochpaß in der Regel einen Impedanzwandler nach, der auch eine Wahl des Gleichspannungspegels ermöglicht.

Zur Filterung zweier, beispielsweise komplementärer Eingangssignale sind zwei symmetrisch aufgebaute Hochpässe erforderlich. Insbesondere in integrierten Schaltungen lassen sich die in der Größenordnung nF liegenden frequenzbestimmenden Kapazitäten nur durch externe Beschaltung realisieren. Oft besitzen die Anschlüsse der Kapazitäten unterschiedliche Gleichspannungspegel, die die Zuverlässigkeit der Schaltung beeinträchtigen können.

Der Erfindung liegt die Aufgabe zugrunde, eine Hochpaß- und Verstärkerschaltung anzugeben, die nur eine Kapazität benötigt, die Entkopplung von Gleich- und Wechselsignalen erlaubt und die Möglichkeit bietet, den Gleichspannungspegel an den Anschlüssen der Kapazität konstant zu halten.

Ep 1 RM / 21.09.1984

Diese Aufgabe wird bei einer Schaltung der eingangs erwähnten Art erfindungsgemäß durch die Merkmale des
Kennzeichens des Patenanspruches 1 gelöst.

Ausgestaltungen des Erfindungsgedankens sind in Unteransprüchen gekennzeichnet.

Die Erfindung wird im folgenden anhand zweier Figuren
näher erläutert. Dabei sind gleiche Elemente mit gleichen Bezugszeichen versehen.

Fig. 1 zeigt eine als Ausführungsbeispiel zu wertende
erfindungsgemäße Schaltung einer Hochpaß- und
Verstärkerschaltung und

Fig. 2 zeigt ein zweites Ausführungsbeispiel einer erfindungsgemäßen Schaltung.

Grundgedanke der Erfindung ist es, die Emitter einer
Differenzverstärkerstufe über eine Kapazität zu entkoppeln. Bis zu einer im wesentlichen durch die Impedanz der Kapazität bestimmten Grenzfrequenz wirkt die
Schaltung wie zwei getrennte Teilschaltungen. Unterhalb
der Grenzfrequenz ist jede Teilschaltung stark gegengekoppelt und besitzt deshalb nur eine geringe Verstärkung. Oberhalb der Grenzfrequenz verhält sich die
Schaltung dagegen wie ein Differenzverstärker mit hohem
Verstärkungsfaktor. Mit nur einer Kapazität läßt sich
somit ein Hochpaß für zwei Eingangssignale verwirklichen, der seine Eigenschaften bei Belastung nicht ändert
und dessen hochfrequente Signale außerdem verstärkt
werden.

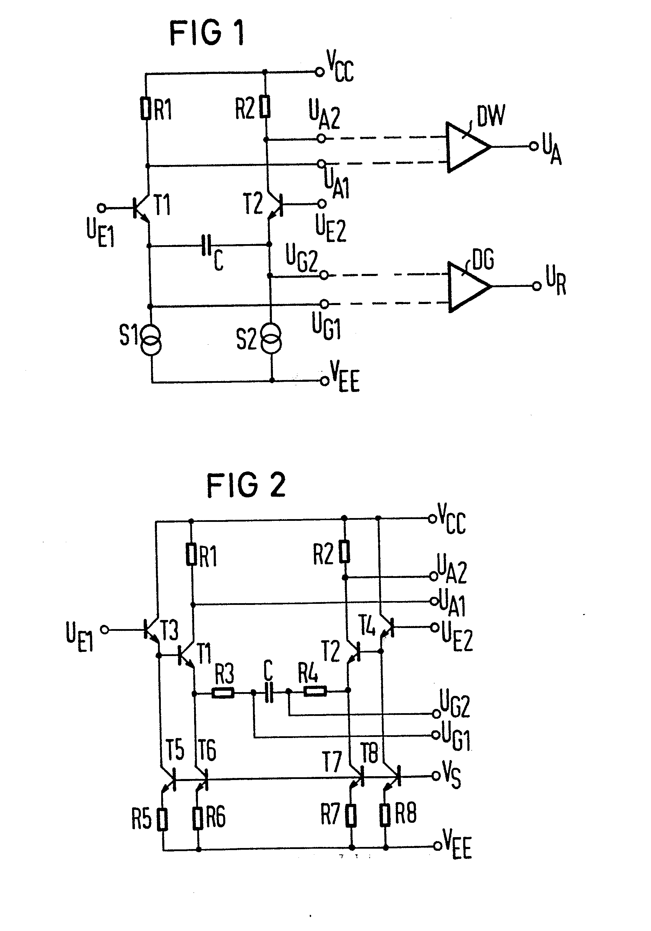

Fig. 1 zeigt ein Ausführungsbeispiel einer erfindungsgemäßen Schaltung. Zwei gleiche npn-Transistoren T1 und
T2 liegen mit ihren Kollektoren über die Widerstände R1
und R2 am Pol $V_{CC}$ der Versorgungsspannungsquelle, während ihre Emitter von den Stromquellen S1 und S2 versorgt werden, deren andere Anschlüsse mit dem Pol $V_{EE}$
der Versorgungsspannungsquelle verbunden sind. Zwischen
die Verbindungspunkte der Emitter von T1 und T2 mit den
Stromquellen S1 und S2 ist eine Kapazität C geschaltet.
Die Eingänge der Schaltung bilden die Basen der Transistoren T1 und T2, an denen die Signale $U_{E1}$ und $U_{E2}$
anliegen. Die Ausgänge der Schaltung stellen die Verbindungspunkte der Kollektoren der Transistoren T1 und
T2 mit den Widerständen R1 und R2 dar, an denen die
Signale $U_{A1}$ und $U_{A2}$ abzugreifen sind.

An den beiden Anschlüssen der erfindungsgemäß zwischen
die Emitter der Transistoren T1 und T2 geschalteten
Kapazität befinden sich die beiden Hilfsausgänge der
Schaltung, an denen die Signale $U_{G1}$ und $U_{G2}$ anliegen.
Die Ausgangssignale und die Signale der Hilfsausgänge
der Schaltung lassen sich beispielsweise mit Operationsverstärkern weiterverarbeiten; so liefert der Ausgang
des Differenzverstärkers DW das Ausgangssignal $U_A$ der
verstärkten hochfrequenten Signalanteile und der Ausgang des Differenzverstärkers DG das Ausgangssignal $U_R$
der gleich- bzw. niederfrequenten Signalanteile.

Bis zu einer im wesentlichen durch die Impedanz der
Kapazität C vorgegebenen Grenzfrequenz sind die beiden
Transistorkreise durch die Kapazität C entkoppelt.
Das Emitterpotential der Transistoren T1 und T2 kann

0176069

in diesem Fall sich ändernden Eingangssignalen $U_{E1}$ und $U_{E2}$ folgen, jedoch stellen die beiden Stromquellen S1 und S2 aufgrund ihres sehr hohen Innenwiderstandes eine starke Gegekopplung dar, so daß die Spannungsverstärkung klein bleibt.

Vorteilhaft lassen sich diese niederfrequenten Signalanteile an den Emittern der Transistoren T1 und T2 bzw. den Anschlüssen der Kapazität C abgreifen, die die Hilfsausgänge der Schaltung bilden. Die so gewonnenen Signale $U_{G1}$ und $U_{G2}$ lassen sich speziell im Hinblick auf die Tatsache weiterverarbeiten, daß die Lebensdauer von Kapazitäten, hier der Kapazität C, bei unterschiedlichen Anschlußpotentialen abnimmt. Beispielsweise läßt sich mit Hilfe eines Differenzverstärkers DG ein Regelsignal $U_R$ gewinnen, das auf die Gleichtaktpegel der erfindungsgemäßen Schaltung und die Arbeitspunkte anderer Schaltungsteile rückwirkt.

Bei Annäherung der Frequenzen der Eingangssignale an die im wesentlichen durch die Ifztqlgv qte Kapazität C bestimmte Grenzfrequenz vermag die Kapazität C die beiden Teilkreise immer weniger zu entkoppeln. Speziell oberhalb der dargelegten Grenzfrequenz ist die Kapazität C als Kurzschluß zwischen den Emittern der Transistoren T1 und T2 aufzufassen. Da die beiden Stromquellen S1 und S2 vorteilhaft den gleichen Strom liefern, bleiben die Emitterpotentiale der Transistoren T1 und T2 bei sich hochfrequent ändernden Eingangssignalen $U_{E1}$ und $U_{E2}$ aus Symmetriegründen konstant. In diesem Fall stellt die Schaltung einen Differenzverstärker dar, dessen verstärkte Ausgangssignale sich an den Kollektoren der Transistoren T1 und T2 abgreifen lassen.

Mit Hilfe der erfindungsgemäßen Schaltung nach Fig. 1 lassen sich die Eingangssignale, insbesondere Gegentakt-Eingangssignale, nach Gleich- und Wechselanteilen trennen, wobei für beide Signalwege dieser belastungsunabhängigen Hochpaßschaltung lediglich eine Kapazität C erforderlich ist.

Fig. 2 stellt ein weiteres Ausführungsbeispiel einer erfindungsgemäßen Schaltung dar, von der nur die auf Fig. 1 bezogenen Unterschiede beschrieben werden. Dem Eingang des Transistors T1 ist der Emitterfolger T3 und dem Eingang des Transistors T2 der Emitterfolger T4 vorgeschaltet. Die npn-Transistoren T3 und T4 werden von je einer Stromquelle versorgt und liegen mit ihren Kollektoren direkt am Pol $V_{CC}$ der Versorgungsspannungsquelle. Die Basen von T3 und T4 bilden die Eingänge der Schaltung, an denen die Eingangssignale $U_{E1}$ und $U_{E2}$ anliegen. T3 und T4 dienen als Impedanzwandler, damit die erfindungsgemäße Hochpaßschaltung vorgeschaltete Schaltungsteile nicht belastet.

Die Stromquellen der in Fig. 2 dargestellten Schaltung sind im Gegensatz zu Fig. 1 ausführlich gezeichnet. Sie enthalten jeweils einen npn-Transistor T5 bis T8, deren Emitter je über einen der Widerstände R5 bis R8 gegen den Pol $V_{EE}$ der Versorgungsspannungquelle geschaltet sind. An den Basen von T5 bis T8 liegt das gemeinsame Potential $V_S$. Die Kollektoren von T5 bis T8 sind in dieser Reihenfolge mit den Emittern von T3, T1, T2 und T4 verbunden. Die Stromquellen aus T6 und R6 bzw. T7 und R7 entsprechen den Stromquellen S1 bzw. S2 in Fig. 1. Die vier Stromquellen liefern vorteilhaft jeweils den gleichen Strom.

Die Anschlüsse der Kapazität C sird je über einen der beiden Widerstände R3 und R4 mit dem Verbindungspunkt des Emitters des Transistors T1 mit dem Kollektor des Transistors T6 bzw. mit dem Verbindungspunkt des Emitters des Transistors T2 mit dem Kollektor des Transistors T7 verbunden. Wie in Fig. 1 bilden die Anschlüsse der Kapazität C, d.h. die Verbindungspunkte der Kapazität C mit den Widerständen R3 und R4 die Hilfsausgänge der Schaltung, an denen die gleich- und niederfrequenten Signalanteile $U_{G1}$ und $U_{G2}$ abzugreifen sind. Die Ausgänge der Schaltung bilden wie in Fig. 1 die Kollektoren der Transistoren T1 und T2.

Die Widerstände R3 und R4 bilden oberhalb der Grenzfrequenz der erfindungsgemäßen Hochpaßschaltung eine interne Gegenkopplung, um eine definierte Differenzverstärkung zu gewährleisten. Ansonsten ist die Funktionsweise der Schaltung mit der in Fig. 1 beschriebenen erfindungsgemäßen Schaltung gleich.


2 Figuren
3 Patentansprüche

Patentansprüche

1. Schaltungsanordnung mit zwei gleichen Transistoren eines Leitungstyps, die je über einen gleich großen Lastwiderstand an einen Pol einer Versorgungsspannungsquelle angeschlossen und von je einem Strom einer Stromquelle versorgt sind, d a d u r c h   g e k e n n z e i c h n e t,   daß zwischen den Emittern der zwei gleichen Transistoren (T1, T2) eine Kapazität (C) angeschlossen ist.

2. Schaltungsanordnung nach Anspruch 1, d a d u r c h   g e k e n n z e i c h n e t,   daß zwischen der Kapazität (C) und dem Emittern der zwei gleichen Transistoren (T1, T2) je ein gleich großer Wmqtenalgq (R3, R4) angeschlossen ist.

3. Schaltungsanordnung nach einem der Ansprüche 1 bis 2, g e k e n n z e i c h n e t   durch an den Anschlüssen der Kapazität (C) liegende Hilfsausgänge.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | US-A-3 323 070 (R. HAYES) <br> * Insgesamt * | 1 | H 03 H 11/12 <br> H 03 H 11/34 <br> H 03 F 3/45 |
| X | JAPANESE JOURNAL OF APPLIED PHYSICS. SUPLEMENTS, Band 22, Suppl. Nr. 22-1, Seiten 129-132, Tokyo, JP; M. OHARA et al.: "Very wide-band silicon bipolar monolithic amplifiers" <br> * Figuren 3-5; Seite 130, Abschnitt 3.1. "A differential amplifier" * | 1 | |
| X | US-A-3 660 773 (M. FREE) <br> * Insgesamt * | 1 | |
| X | EP-A-0 101 201 (NIPPON TELEGRAPH) <br> * Figuren 2,5-8,21-34; Seite 9, Zeile 8 - Seite 10, Zeile 11; Seite 11, Zeile 18 - Seite 15, Zeile 11; Seite 21, Zeile 24 - Seite 31, Zeile 22 * | 1 | **RECHERCHIERTE SACHGEBIETE (Int. Cl.4)** <br><br> H 03 H <br> H 03 F |

Der vorliegende Recherchenbericht wurde für alle Patentansprüche erstellt.

| Recherchenort | Abschlußdatum der Recherche | Prüfer |
|---|---|---|
| DEN HAAG | 19-12-1985 | DECONINCK E.F.V. |